# EUROPÄISCHE PATENTSCHRIFT

(11) **EP 0 762 485 B1**
(45) Veröffentlichungstag und Bekanntmachung des Hinweises auf die Patenterteilung: **11.12.2002**
(21) Anmeldenummer: 96113851.8
(22) Anmeldetag: 29.08.1996
(51) Int. Cl.: H01L 21/28, H01L 21/336, H01L 21/762

(54) **Verfahren zur Kontaktlochherstellung**
Method of manufacturing a contact hole
Méthode de fabrication d'un trou de contact

(30) Priorität: 01.09.1995 DE 19532380
(43) Veröffentlichungstag der Anmeldung: 12.03.1997
(73) Patentinhaber: Infineon Technologies AG, 81669 München (DE)
(72) Erfinder: Kerber, Martin, Dr.rer.nat., 81827 München (DE)
(74) Vertreter: Kindermann, Peter

(56) Entgegenhaltungen:
- RAYNAUD C ET AL: "HIGH PERFORMANCE SUBMICRON SOI DEVICES WITH SILICON FILM THICKNESS BELOW 50NM" INTERNATIONAL SOI CONFERENCE PROCEEDINGS, NANTUCKET ISLAND, OCT. 3 - 6, 1994, 3. Oktober 1994, Seite 55/56 XP000512317 INSTITUTE OF ELECTRICAL AND ELECTRONICS ENGINEERS
- FAYNOT O ET AL: "HIGH PERFORMANCE ULTRATHIN SOI MOSFET'S OBTAINED BY LOCALIZED OXIDATION" IEEE ELECTRON DEVICE LETTERS, Bd. 15, Nr. 5, 1. Mai 1994, Seiten 175-177, XP000449442
- CHOI JH ET AL: "EXTREMELY THIN FILM (10NM) SOI MOSFET CHARACTERISTICS INCLUDING INVERSION LAYER TO ACCUMULATION LAYER TUNNELING" INTERNATIONAL ELECTRON DEVICES MEETING 1994,Dezember 1994, Seiten 645-648, XP000585572 INSTITUTE OF ELECTRICAL AND ELECTRONICS ENGINEERS

## Beschreibung

Die Erfindung betrifft ein Verfahren zur Kontaktlochherstellung bei MOS-Schaltkreisen in SOI-Technik mit einer Oxidschicht und einer darüberliegenden Siliziumschicht.

In der SOI-Technik werden Schaltkreise in einem dünnen Siliziumfilm ausgebildet, der auf einem Isolator angeordnet ist. Die Eigenschaften dieser Schaltkreise sind insbesondere dann günstig, wenn die aktive Siliziumschicht so dünn ist, daß eine sogenannte "fully depleted", also eine ladungsträgerfreie Zone im aktiven Siliziumbereich entsteht. Bei sogenannten "surface channel-Schaltungen" und Anwendung der Sub-µm-Technologie liegt die dazu benötigte Dicke vorzugsweise in der Größenordnung von 50 bis 80 nm. Diese extrem dünnen Siliziumschichten stellen besondere Anforderungen an die Prozeßführung, insbesondere an die isotropen Ätzungen von Oxidschichten, da diese nicht beliebig selektiv zu Silizium sind. Kann man sich bei den Spacerätzungen durch geänderte Prozeßfolgen helfen, so ist bei der Kontaktlochätzung eine Einätzung unvermeidlich. Außerdem muß nach der Kontaktlochätzung neben den Polymeren auch noch die oberste Siliziumschicht entfernt werden. Diese ist stark gestört und würde einen erhöhten Kontaktwiderstand verursachen.

Es ist bekannt, die kritische Kontaktlochätzung durch Wahl eines SOI-Grundmaterials zu umgehen, dessen Siliziumschicht etwas dicker ist, als es für MOS-Schaltungen mit einem vollständig ladungsträgerfreien aktiven Bereich erforderlich wäre. In einem ersten Prozeßblock wird dabei das Silizium im aktiven Bereich auf die gewünschte Dicke gedünnt. Da aber auf dem SOI-Grundmaterial unterschiedliche Dicken vorliegen, ist jetzt eine weitere Prozeßführung mit einer Isolationstechnik durch lokale vollständige Oxidation der Siliziumschicht nur schwer möglich, da bei dieser Technik die Prozeßführung auf die maximale Siliziumschicht abgestellt werden muß. In diesem Fall liegen jedoch auch Bereiche mit einer deutlich kleineren Dicke vor, in denen sich die Oxidation in lateraler Richtung unter die dabei verwendete Nitridmaske fortsetzt, wodurch ein unvertretbar großer Maßverlust gerade in den kritischen aktiven Bereichen entsteht. Anstelle der lokalen vollständigen Oxidation kann auch eine MESA-Ätzung angewandt werden. Dabei treten aber unerwünschte parasitäre Seitenwandtransistoren und Gateoxiddünnungen an der MESA-Kante auf, deren Kontrolle wieder weitere Prozeßmaßnahmen erfordert.

Aus der Druckschrift RAYNAUD C ET AL: "HIGH PERFORMANCE SUB-MICRON SOI DEVICES WITH SILICON FILM THICKNESS BELOW 50NM" INTERNATIONAL SOI CONFERENCE PROCEEDINGS, NANTUCKET ISLAND, OCT. 3 - 6, 1994, 3. Oktober 1994, Seite 55/56 XP000512317 INSTITUTE OF ELECTRICAL AND ELECTRONICS ENGINEERS ist ein Verfahren zur Herstellung von ultradünnen MOSFET-Transistoren auf einem SOI-Substrat bekannt, wobei eine Siliziumschicht mittels LOCOS-Technik gedünnt und isoliert wird.

Ferner offenbart die Druckschrift FAYNOT O ET AL: "HIGH PERFORMANCE ULTRATHIN SOI MOSFET'S OBTAINED BY LOCALIZED OXIDATION" IEEE ELECTRON DEVICE LETTERS, Bd. 15, Nr. 5, 1. Mai 1994, Seiten 175-177, XP000449442 ein vergleichbares Verfahren zur Herstellung von MOSFET-Transistoren mit ultradünner Halbleiterschicht, wobei ein SOI-Substrat mittels eines LO-COS-Verfahrens bearbeitet und anschließend zum Dünnen lokal abgetragen wird.

Aus der Druckschrift CHOI JH ET AL: "EXTREMELY THIN FILM (10NM) SOI MOSFET CHARACTERISTICS INCLUDING INVERSION LAYER TO ACCUMULATION LAYER TUNNELING" INTERNATIONAL ELECTRON DEVICES MEETING 1994,Dezember 1994, Seiten 645-648, XP000585572 INSTITUTE OF ELECTRICAL AND ELECTRONICS ENGINEERS, ist ebenfalls ein Verfahren zur Herstellung von MOSFET-Transistoren mit Köntaktlöchern bekannt, wobei bereits in einem ersten Schritt die Dicken eines aktiven Bereichs mittels eines LO-COS-Verfahrens eingestellt werden.

Der Erfindung liegt demgegenüber die Aufgabe zugrunde, ein Verfahren der eingangs genannten Art zu schaffen, bei dem die Herstellung der Kontaktlöcher sowie die gesamte Prozeßführung bei gleichzeitiger Vorsehung eines extrem dünnen aktiven Bereichs besonders sicher ist.

Die Lösung dieser Aufgabe erfolgt mit den Merkmalen des Anspruchs 1. Vorteilhafte Weiterbildungen sind in den Unteransprüchen beschrieben.

Nach dem Grundgedanken der Erfindung wird die auf der Oxidschicht liegende Siliziumschicht, die auch als Body bezeichnet wird, mit einer Dicke ausgebildet, die größer ist als die für die aktiven Bereiche der MOS-Schaltkreise erforderliche Dicke, eine erste Maske auf die Kontaktlochbereiche aufgebracht und die nicht abgedeckten Bereiche auf eine für die aktiven Bereiche geeignete Dicke gedünnt und mit einer zweiten Maske die aktiven Bereiche, die Zuleitungsbereiche und Kontaktlochbereiche abgedeckt, und die nicht abgedeckten Bereiche mit einer LOCOS-Isolation oxidiert und in weiteren Schritten ein Anschluß an den aktiven Bereich und eine Isolierschicht erzeugt, wobei die eigentliche Kontaktlochätzung durch die Isolierschicht hindurch erfolgt.

Durch dieses Verfahren werden extrem dünne Siliziumbereiche für "fully depleted" MOS-Schaltungen und Bereiche mit lokal dickerem Silizium für eine ausreichende Prozeßsicherheit bei der Herstellung von Kontaktlöchern geschaffen und gleichzeitig eine mit der LOCOS-Isolation verträgliche Prozeßführung angewandt, mit der eine besonders exakte Oxidierung durchführbar ist. Die Kontaktlochbereiche und deshalb auch die ursprüngliche Siliziumschicht werden verdickt ausgebildet, da bei der letztendlichen Kontaktlochätzung eine Einätzung in die Kontaktlochbereiche unvermeidlich ist und die Siliziumschicht in diesem Bereich nicht vollständig entfernt werden darf.

In einer bevorzugten Weiterbildung der Erfindung werden mit der ersten Maske auch die Zuleitungsbereiche, insbesondere der Source-Zuleitungsbereich, abgedeckt. Dadurch kann der Zuleitungswiderstand vom Kontaktbereich bis an den aktiven Bereich reduziert werden. Diese Maßnahme ist bei der Source-Zuleitung von besonderer Relevanz, kann aber auch bei der Drain-Zuleitung vorteilhaft eingesetzt werden.

Die Dünnung der nicht von der ersten Maske abgedeckten Bereiche wird günstigerweise ebenfalls mit einer LOCOS-Technik durchgeführt, da diese eine sichere Prozeßführung ermöglicht. Um sicherzustellen, daß die LOCOS-Isolation bei Verwendung der zweiten Maske nur in Bereichen stattfindet, die im ersten Dünnungsschritt bereits gedünnt worden sind, wird die zweite Maske größer als die erste ausgebildet, so daß auch um die Kontaktlochbereiche herum ein gewisser Vorhalt entsteht.

Die Anwendung dieser Technik bietet bei CMOS-Schaltkreisen und NMOS-Transistoren besondere Vorteile.

Nachfolgend wird die Erfindung anhand eines in der Zeichnung dargestellten Ausführungsbeispiels weiter erläutert. Die schematischen Darstellungen zeigen beispielhaft verschiedene Stadien des Herstellungsprozesses für CMOS-Transistoren mit lokal dickerem Silizium im Bereich der Kontaktlöcher und den Bereichen der Transistorzuleitungen. Dabei zeigt
- Figur 1: den Verfahrensstand nach Anwendung einer ersten Maskentechnik;
- Figur 2: den Verfahrensstand nach Anwendung einer zweiten Maskentechnik; und
- Figur 3: den Zustand im einem Endstadium des Verfahrens.

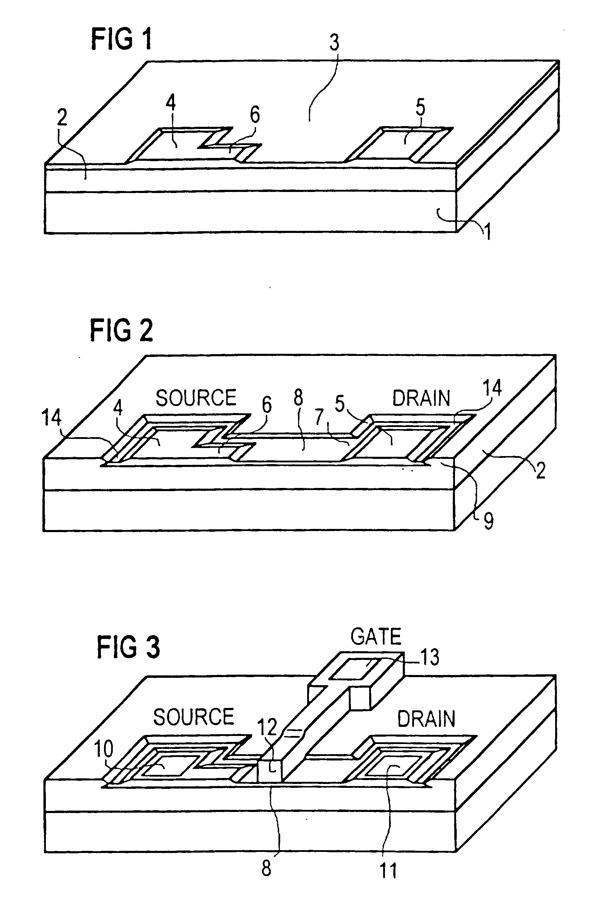

In Figur 1 ist das SOI-Grundmaterial dargestellt, welches im wesentlichen aus einem Substrat 1, einer vergrabenen Oxidschicht 2 und einer Siliziumschicht 3, die auch als Body bezeichnet wird, besteht. Die Dicke der Siliziumschicht 1 beträgt in etwa 170 nm. Damit ist die Siliziumschicht so dick, daß nach den prozeßbedingten Dünnungen die bei der Kontaktlochätzung freiliegenden Stellen eine für Overetch und Kontaktlochnachbehandlung ausreichende Dicke aufweisen. Bei einer ersten lokalen Oxidationsmaske, die aus Nitrid oder Oxynitrid bestehen kann, werden nun die Kontaktlochbereiche 4, 5 für den Source- und den Drainanschluß und auch der Zuleitungsbereich 6, im Ausführungsbeispiel nur in der Source-Zuleitung ausgeführt, abgedeckt. Die nicht abgedeckten Bereiche werden soweit oxidiert, daß die Restdicke der Siliziumschicht 1 so dünn ist, daß sie den Anforderungen für "fully depleted", also für vollständig verarmte und somit ladungsträgerfreie MOS-Einrichtungen entspricht. Dabei wird die außerhalb der abgedeckten Bereiche liegende Siliziumschicht zunächst oxidiert und dann das Oxid abgetragen, so daß die in Figur 1 dargestellte dünne Siliziumschicht außerhalb der abgedeckten Bereiche entsteht. Dieser Verfahrensschritt wird durch lokale Oxidation des Siliziums, also durch eine Art LOCOS-Technik erreicht.

Im folgenden wird eine zweite Maske aufgebracht, mit der die Kontaktlochbereiche 4, 5, der aktive Bereich 8 sowie die Zuleitungsbereiche 6 und 7 abgedeckt werden. Diese Maske ist gegenüber der ersten Maske vergrößert, so daß sich ein Vorhalt 14 rings um die erhöhten Kontaktlochbereiche 4, 5 ausbildet, durch den die Prozeßsicherheit weiter erhöht wird. Außerhalb der wiederum aus Nitrid oder Oxynitrid bestehenden Oxidationsmaske wird mit der LOCOS-Technik eine Oxidation durchgeführt. Dabei ist herauszustellen, daß die LOCOS-Technik vollständig auf einem Bereich durchgeführt wird, der im ersten Verfahrensschritt gedünnt worden ist und die Oxidation somit auf die Dicke der zuvor gedünnten Siliziumschicht abgestimmt werden muß. Da in dem prozessierten Bereich keine unterschiedlichen Dicken vorkommen, ist eine deutliche laterale Unteroxidation ausgeschlossen. Durch die LOCOS-Oxidation entsteht außerhalb der Kontaktlochbereiche 4, 5 der Zuleitungsbereiche 6, 7 des aktiven Bereichs 8 und der Vorhalte 14 eine erhöhte LOCOS-Isolationsschicht 9.

In Figur 3 ist der Verfahrensstand nach einigen weiteren Schritten dargestellt. So wird ein Gateanschluß 12 erzeugt, dessen Siliziumzuführung auf den aktiven Bereich 8 geführt ist, der durch die vorausgehenden Prozeßschritte so dünn ist, daß das Silizium möglichst vollständig verarmt ist. Auf die dargestellte Struktur wird noch eine in Figur 3 nicht dargestellte Isolationsschicht aufgebracht, durch die die Kontaktlochätzungen erfolgen. In der Figur sind das Source-Kontaktloch 10, das Drain-Kontaktloch 11 und das Gate-Kontaktloch 13 dargestellt. Bei der Kontaktlochätzung wird ein Teil der Kontaktlochbereiche 4, 5 abgetragen, wobei jedoch die Siliziumschicht in diesem Bereich nicht vollständig entfernt wird, da durch das beschriebene Verfahren diese Bereiche lokal dicker sind und dadurch die Prozeßsicherheit erhöht wird. Der Zuleitungsbereich 6 vom Source-Kontaktlochbereich 4 zum aktiven Bereich 8 ist ebenfalls verdickt ausgebildet, um den Zuleitungswiderstand zu reduzieren. In gleicher Weise könnte auch der Zuleitungsbereich 7 vom Drain-Kontaktlochbereich 5 zum aktiven Bereich 8 ausgebildet werden.

## Patentansprüche

1. Verfahren zur Kontaktlochherstellung bei MOS-Schaltkreisen auf einem SOI Substrat mit einer Oxidschicht (2) und einer darüber liegenden Siliziumschicht (3), bei dem
die Siliziumschicht (3) mit einer Dicke ausgebildet wird, die größer ist als die für die aktiven Bereiche der MOS-Schaltkreise erforderliche Dicke,
in einem ersten Schritt eine erste Maske auf die Kontaktlochbereiche (4, 5) aufgebracht und die nicht abgedeckten Bereiche auf eine für die aktiven Bereiche geeignete Dicke gedünnt werden,
in einem zweiten Schritt mit einer zweiten Maske die aktiven Bereiche (8), die zwischen den Kontaktlochbereichen und den aktiven Bereichen liegende Zuleitungsbereiche (6, 7) und die Kontaktlochbereiche (4, 5) abgedeckt und die nicht abgedeckten Bereiche mit einer LOCOS-Isolation isoliert werden, und
in weiteren Schritten ein Anschluß an den aktiven Bereich und eine Isolierschicht erzeugt werden, durch die die Kontaktloch-Ätzung erfolgt **dadurch gekennzeichnet,**
**daß** im zweiten Schritt die LOCOS-Technik vollständig auf einem Bereich durchgeführt wird, der im ersten Schritt gedünnt worden ist.

2. Verfahren nach Anspruch 1,
**dadurch gekennzeichnet,**
**daß** mit der ersten Maske auch die Zuleitungsbereiche (6, 7), insbesondere der Source-Zuleitungsbereich (6), abgedeckt werden.

3. Verfahren nach einem der vorhergehenden Ansprüche,
**dadurch gekennzeichnet,**
**daß** die im ersten Schritt angewandte Dünnung durch eine Oxidation der außerhalb der abgedeckten Bereiche liegenden Siliziumschicht und die anschließende Abtragung des Oxides erfolgt.

4. Verfahren nach einem der vorhergehenden Ansprüche,
**dadurch gekennzeichnet,**
**daß** die zweite Maske größer ist als die erste Maske und Vorhalte (14) um die Kontaktlochbereiche (4, 5) gebildet werden.

5. Verfahren nach einem der vorhergehenden Ansprüche,
**dadurch gekennzeichnet,**
**daß** CMOS-Schaltungen oder NMOS-Transistoren hergestellt werden.

## Claims

1. Method for contact hole production for MOS circuits on an SOI substrate having an oxide layer (2) and having a silicon layer (3) located above it, in which
the silicon layer (3) is formed with a thickness which is greater than the thickness required for the active areas of the MOS circuits,
in a first step, a first mask is applied to the contact hole areas (4, 5) and those areas which are not covered are thinned to a thickness which is suitable for the active areas,
in a second step, using a second mask, the active areas (8), the supply line areas (6, 7) located between the contact hole areas and the active areas, and the contact hole areas (4, 5) are covered, and those areas which are not covered are insulated using LOCOS insulation, and
in further steps, a connection is produced to the active area and to an insulating layer, through which the contact hole etching takes place,
**characterized**
**in that**, in the second step, the LOCOS technique is carried out completely on an area which has been thinned in the first step.

2. Method according to Claim 1,
**characterized**
**in that** the supply line areas (6, 7), in particular the source supply line area (6), are also covered by the first mask.

3. Method according to one of the preceding claims, **characterized**
**in that**, the thinning which is carried out in the first step is carried out by oxidation of the silicon layer located other than in the covered areas, and the oxide is then removed.

4. Method according to one of the preceding claims, **characterized**
**in that** the second mask is larger than the first mask, and land areas (14) are formed around the contact hole areas (4, 5).

5. Method according to one of the preceding claims, **characterized**
**in that** CMOS circuits or NMOS transistors are produced.

## Revendications

1. Procédé de fabrication d'un trou métallisé dans des circuits MOS sur un substrat SOI comprenant une couche (2) d'oxyde et, au-dessus, une couche (3) de silicium, dans lequel
on constitue la couche (3) de silicium en une épaisseur qui est supérieure à l'épaisseur nécessaire pour les parties actives du circuit MOS,
dans un premier stade, on dépose un premier masque sur les parties (4, 5) de trou métallisé et on amincit les parties non recouvertes à une épaisseur appropriée aux parties actives,
dans un deuxième stade, on revêt d'un deuxième masque les parties (8) actives, les parties (6, 7) d'entrée de courant comprises entre les parties de trou métallisé et les parties actives et les parties (4, 5) de trou métallisé et on isole par un isolant LOCOS les parties non revêtues, et
dans d'autres stades, on produit une connexion sur la partie active et une couche isolante à travers laquelle s'effectue l'attaque pour le trou métallisé,
**caractérisé en ce que**
dans le deuxième stade, on effectue la technique LOCOS entièrement sur une partie qui a été amincie dans le premier stade.

2. Procédé suivant la revendication 1, **caractérisé en ce qu'**on revêt par le premier masque également les parties (6, 7) d'entrée de courant, notamment la partie (6) d'entrée de source.

3. Procédé suivant l'une des revendications précédentes, **caractérisé en ce que** l'on effectue l'amincissement utilisé dans le premier stade par une oxydation de la couche de silicium se trouvant à l'extérieur des parties revêtues et par l'enlèvement de l'oxyde qui a lieu ensuite.

4. Procédé suivant l'une des revendications précédentes, **caractérisé en ce que** le deuxième masque est plus grand que le premier masque et il est formé des réserves (14) autour des parties (4, 5) de trou de contact.

5. Procédé suivant l'une des revendications précédentes, **caractérisé en ce que** l'on fabrique des circuits CMOS ou des transistors NMOS.
